# EUROPEAN PATENT APPLICATION

(11) **EP 4 496 006 A1**
(43) Date of publication of application: **22.01.2025**
(21) Application number: 24150285.5
(22) Date of filing: 04.01.2024
(51) Int. Cl.: H01L 29/423, H01L 29/78, H01L 29/786, H01L 21/336

(54) **EXTENDED-DRAIN METAL-OXIDE-SEMICONDUCTOR DEVICES WITH A DUAL-THICKNESS GATE DIELECTRIC LAYER**

(30) Priority: 18.07.2023 US 202318223117
(71) Applicant: GLOBALFOUNDRIES Singapore Pte. Ltd., Singapore 738406 (SG)
(72) Inventor: LIU, Fangyue, 738406 Singapore (SG); TOH, Rui Tze, 738406 Singapore (SG); XIN, Chen, 738406 Singapore (SG); OON, Boon Guan, 738406 Singapore (SG); WONG, Jason Kin Wei, 738406 Singapore (SG); CHONG, Yung Fu, 738406 Singapore (SG)
(74) Representative: Lambacher, Michael

(57) **Abstract**

Structures for an extended-drain metal-oxide-semiconductor device and methods of forming a structure for an extended-drain metal-oxide-semiconductor device. The structure comprises a semiconductor layer, a source region, a drain region, and a gate positioned between the source region and the drain region. The gate includes a gate conductor layer, a first gate dielectric layer having a first thickness, and a second gate dielectric layer having a second thickness greater than the first thickness. The first gate dielectric layer is disposed on a top surface of the semiconductor layer, and the second gate dielectric layer includes a first section on the top surface of the semiconductor layer and a second section adjacent to a sidewall of the semiconductor layer. The gate conductor layer has an overlapping relationship with the first gate dielectric layer, the first section of the second gate dielectric layer, and the second section of the second gate dielectric layer.

## Description

### BACKGROUND

This disclosure relates generally to semiconductor devices and integrated circuit fabrication and, more specifically, to structures for an extended-drain metal-oxide-semiconductor device and methods of forming a structure for an extended-drain metal-oxide-semiconductor device.

High-voltage integrated circuits used, for example, in microwave/radiofrequency power amplifiers typically require specialized device structures capable of withstanding higher voltages. Extended-drain metal-oxide-semiconductor (EDMOS) devices, also known as laterally-diffused metal-oxide-semiconductor (LDMOS) devices, are designed to handle such higher voltages by incorporating additional features, such as an extended drain, that promote the higher voltage handling capability. The breakdown voltage and prompt shift of an extended-drain metal-oxide-semiconductor device may be limited by charge trapping centers at the drift region or under the gate.

Improved structures for an extended-drain metal-oxide-semiconductor device and methods of forming an extended-drain metal-oxide-semiconductor device are needed.

### SUMMARY

In an embodiment, a structure for an extended-drain metal-oxide-semiconductor device is provided. The structure comprises a semiconductor layer including a sidewall and a top surface, a source region in the semiconductor layer, a drain region in the semiconductor layer, and a gate positioned between the source region and the drain region. The gate includes a gate conductor layer, a first gate dielectric layer having a first thickness, and a second gate dielectric layer having a second thickness greater than the first thickness. The first gate dielectric layer is disposed on the top surface of the semiconductor layer. The second gate dielectric layer includes a first section on the top surface of the semiconductor layer and a second section adjacent to the sidewall of the semiconductor layer. The gate conductor layer has an overlapping relationship with the first gate dielectric layer, the first section of the second gate dielectric layer, and the second section of the second gate dielectric layer.

The structure may further comprise a shallow trench isolation region in the semiconductor layer; the second section of the second gate dielectric layer may overlap with the shallow trench isolation region.

The structure may further comprise a substrate, and a dielectric layer on the substrate; the semiconductor layer of the structure may be disposed on the dielectric layer; the shallow trench isolation region may penetrate through the semiconductor layer to the dielectric layer.

Further, the semiconductor layer of the structure may include a device region surrounded by the shallow trench isolation region; the device region may include a portion that projects above the shallow trench isolation region; optionally, the first sidewall of the semiconductor layer may extend from the shallow trench isolation region to the top surface of the semiconductor layer. Further, the first sidewall may extend from the source region to the drain region.

The semiconductor layer may further include a second sidewall; the second gate dielectric layer may include a third section adjacent to the second sidewall of the semiconductor layer; optionally, the second section of the second gate dielectric layer may be disposed on the first sidewall of the semiconductor layer, and the third section of the second gate dielectric layer may be disposed on the second sidewall of the semiconductor layer.

Further, the first section of the second gate dielectric layer may extend across the top surface of the semiconductor layer from the second section of the second gate dielectric layer to the third section of the second gate dielectric layer. Additionally or alternatively, the first gate dielectric layer may extend across the top surface of the semiconductor layer from the second section of the second gate dielectric layer to the third section of the second gate dielectric layer.

Further, the first sidewall of the semiconductor layer may be aligned parallel to the second sidewall of the semiconductor layer.

Further, the second section of the second gate dielectric layer may be laterally between the gate conductor layer and the semiconductor layer at the first sidewall, and the third section of the second gate dielectric layer may be laterally between the gate conductor layer and the semiconductor layer at the second sidewall. Additionally or alternatively, the gate conductor layer may overlap with a portion of the second section of the second gate dielectric layer, and the gate conductor layer may overlap with a portion of the third section of the second gate dielectric layer.

Further, the second section of the second gate dielectric layer may be disposed on the first sidewall of the semiconductor layer. Optionally, the second section of the second gate dielectric layer may directly contact the first sidewall of the semiconductor layer.

Further, the gate conductor layer may overlap with a first portion of the second section of the second gate dielectric layer. Moreover, the drain region may include a first doped region in the semiconductor layer, the source region may include a second doped region in the semiconductor layer, and the second section of the second gate dielectric layer may include a second portion adjacent to the first doped region, and the second section of the second gate dielectric layer may include a third portion adjacent to the second doped region.

Further, the first section of the second gate dielectric layer may be vertically between the gate conductor layer and the semiconductor layer, and the second section of the second gate dielectric layer may be laterally between the gate conductor layer and the semiconductor layer at the first sidewall.

Further, the second thickness of the second gate dielectric layer may be in a range of about 100 nanometers to about 300 nanometers.

In an embodiment, a method of forming a structure for an extended-drain metal-oxide-semiconductor device is provided. The method comprises forming a source region in a semiconductor layer, forming a drain region in the semiconductor layer, and forming a gate positioned between the source region and the drain region. The gate includes a gate conductor layer, a first gate dielectric layer having a first thickness, and a second gate dielectric layer having a second thickness greater than the first thickness. The first gate dielectric layer is disposed on a top surface of the semiconductor layer. The second gate dielectric layer includes a first section on the top surface of the semiconductor layer and a second section adjacent to a sidewall of the semiconductor layer. The gate conductor layer has an overlapping relationship with the first gate dielectric layer, the first section of the second gate dielectric layer, and the second section of the second gate dielectric layer.

### BRIEF DESCRIPTION OF THE DRAWINGS

The accompanying drawings, which are incorporated in and constitute a part of this specification, illustrate various embodiments of the invention and, together with a general description of the invention given above and the detailed description of the embodiments given below, serve to explain the embodiments of the invention. In the drawings, like reference numerals are used to indicate like features in the various views.
FIG. 1 is a top view of a structure at an initial fabrication stage in accordance with embodiments of the invention.
FIG. 2 is a cross-sectional view taken generally along line 2-2 in FIG. 1.
FIG. 2A is a cross-sectional view taken generally along line 2A-2A in FIG. 1.
FIG. 3 is a top view of the structure at a fabrication stage subsequent to FIGS. 1, 2, 2A.
FIG. 4 is a cross-sectional view taken generally along line 4-4 in FIG. 3.
FIG. 4A is a cross-sectional view taken generally along line 4A-4A in FIG. 3.
FIG. 5 is a top view of the structure at a fabrication stage subsequent to FIGS. 3, 4, 4A.
FIG. 6 is a cross-sectional view taken generally along line 6-6 in FIG. 5.
FIG. 6A is a cross-sectional view taken generally along line 6A-6A in FIG. 5.
FIG. 6B is a cross-sectional view taken generally along line 6B-6B in FIG. 5.
FIGS. 7, 7A, 7B are cross-sectional views of the structure at a fabrication stage subsequent to FIGS. 5, 6, 6A, 6B.

### DETAILED DESCRIPTION

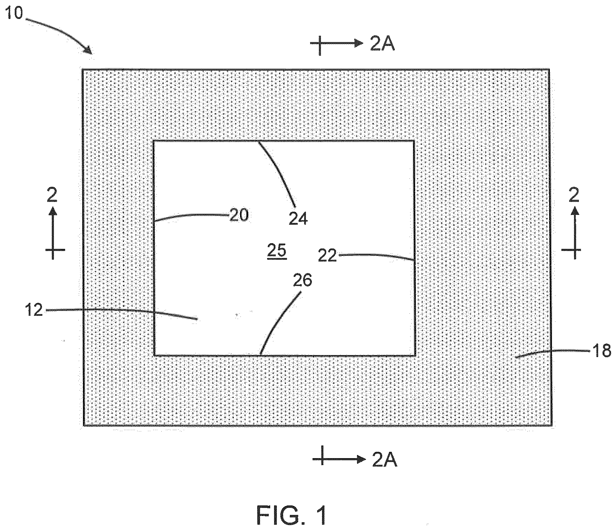

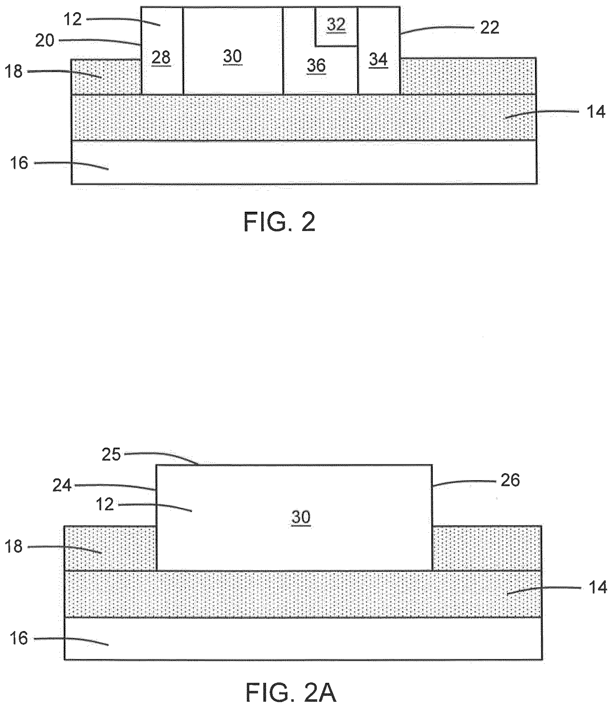

With reference to FIGS. 1, 2, 2A and in accordance with embodiments of the invention, a structure 10 for an extended-drain metal-oxide-semiconductor device may be formed using a semiconductor-on-insulator substrate that includes a semiconductor layer 12, a buried insulator layer 14, and a semiconductor substrate 16. The semiconductor layer 12 and the semiconductor substrate 16 may be comprised of a semiconductor material, such as single-crystal silicon. The buried insulator layer 14 may be comprised of a dielectric material, such as silicon dioxide. The semiconductor layer 12 is separated from the semiconductor substrate 16 by the dielectric material of the intervening buried insulator layer 14. The buried insulator layer 14 has a lower interface with the semiconductor substrate 16 and an upper interface with the semiconductor layer 12. The semiconductor layer 12 is electrically isolated from the semiconductor substrate 16 by the buried insulator layer 14.

A shallow trench isolation region 18 may be formed in the semiconductor layer 12. In an embodiment, the shallow trench isolation region 18 may be formed by applying and patterning a hardmask, etching trenches using the patterned hardmask, depositing a dielectric material (e.g., silicon dioxide) in the trenches, and planarizing with chemical-mechanical polishing. The shallow trench isolation region 18 may surround a device region of the semiconductor layer 12. In an embodiment, the shallow trench isolation region 18 may penetrate fully through the semiconductor layer 12 to the buried insulator layer 14.

The semiconductor layer 12 may include an upper portion comprised of an epitaxial semiconductor material that is added to thicken the semiconductor layer 12 in the device region. In an embodiment, the epitaxial semiconductor material may be added to the semiconductor layer 12 after the shallow trench isolation region 18 is formed. The epitaxial semiconductor material added to the semiconductor layer 12 may be comprised of a semiconductor material, such as single-crystal silicon, that is formed by a selective epitaxial growth process.

The upper portion of the thickened semiconductor layer 12 projects in elevation above the level of the shallow trench isolation region 18. The upper portion of the semiconductor layer 12 is raised relative to the shallow trench isolation region 18. The upper portion of the semiconductor layer 12 may have a sidewall 20, a sidewall 22 opposite from the sidewall 20, a sidewall 24, a sidewall 26 opposite from the sidewall 24, and a top surface 25. The sidewalls 20, 22, 24, 26, which are arranged about the perimeter of the upper portion of the semiconductor layer 12, may be shared with the lower portion of the semiconductor layer 12. In an embodiment, the sidewall 24 of the semiconductor layer 12 may be aligned parallel or substantially parallel to the sidewall 26 of the semiconductor layer 12. The sidewalls 20, 22, 24, 26 of the upper portion of the semiconductor layer 12 may extend in a vertical direction from the shallow trench isolation region 18 to the top surface 25 of the semiconductor layer 12. The sidewalls 24, 26 of the upper portion of the semiconductor layer 12 may extend in a lateral direction from the sidewall 20 to the sidewall 22.

The structure 10 may include doped regions 28, 30, 32 that are formed in respective portions of the semiconductor layer 12. The doped region 28 and the doped region 30 may extend in a vertical direction over a full thickness of the semiconductor layer 12 to the buried insulator layer 14. The doped region 32 may extend over a partial thickness of the semiconductor layer 12. The doped regions 28, 30, 32 may extend in a lateral direction from the sidewall 24 to the sidewall 26, and the doped regions 28, 30, 32 may adjoin the top surface 25.

In an embodiment, the doped regions 28, 30, 32 may contain a concentration of an n-type dopant (e.g., arsenic or phosphorus) to provide n-type conductivity. The doped region 28 may be formed by selectively implanting ions, such as ions including the n-type dopant, with an implantation mask having an opening defining the intended location for the doped region 28 in the semiconductor layer 12. The doped region 30 may be formed by selectively implanting ions, such as ions including the n-type dopant, with an implantation mask having an opening defining the intended location for the doped region 30 in the semiconductor layer 12. The doped region 32 may be formed by selectively implanting ions, such as ions including the n-type dopant, with an implantation mask having an opening defining the intended location for the doped region 32 in the semiconductor layer 12. The implantation conditions (e.g., ion species, dose, kinetic energy) may be selected to tune the electrical and physical characteristics of the doped regions 28, 30, 32. The doped regions 28, 32 may be heavily doped with the n-type dopant, and the doped region 30 may be lightly doped with a lower concentration of the n-type dopant than the doped regions 28, 32.

The structure 10 may include doped regions 34, 36 that are formed in respective portions of the semiconductor layer 12. The doped regions 34, 36 may each extend in a vertical direction over a full thickness of the semiconductor layer 12 to the buried insulator layer 14. The doped region 32 may be disposed in a portion of the doped region 36 that is adjacent to the doped region 34. The doped regions 34, 36 may extend in a lateral direction from the sidewall 24 to the sidewall 26, and the doped regions 34, 36 may adjoin the top surface 25.

In an embodiment, the doped regions 34, 36 may contain a concentration of a p-type dopant (e.g., boron) to provide p-type conductivity. The doped region 34 may be formed by selectively implanting ions, such as ions including the p-type dopant, with an implantation mask having an opening defining the intended location for the doped region 34 in the semiconductor layer 12. The doped region 36 may be formed by selectively implanting ions, such as ions including the p-type dopant, with an implantation mask having an opening defining the intended location for the doped region 36 in the semiconductor layer 12. The implantation conditions (e.g., ion species, dose, kinetic energy) may be selected to tune the electrical and physical characteristics of the doped regions 34, 36. The doped region 34 may be heavily doped with the p-type dopant, and the doped region 36 may be more lightly doped with a lower concentration of the p-type dopant than the doped region 34.

The doped region 28 may define a drain region of an extended-drain metal-oxide-semiconductor device, the doped region 30 may define a drift region of the extended-drain metal-oxide-semiconductor device, and the doped region 32 may define a source region of the extended-drain metal-oxide-semiconductor device. The doped region 36 may define a body of the extended-drain metal-oxide-semiconductor device, and the doped region 34 may define a body contact. The sidewalls 24, 26, which border the drain region, the source region, the drift region, the body, and the body contact, extend in a lateral direction from the source region to the drain region.

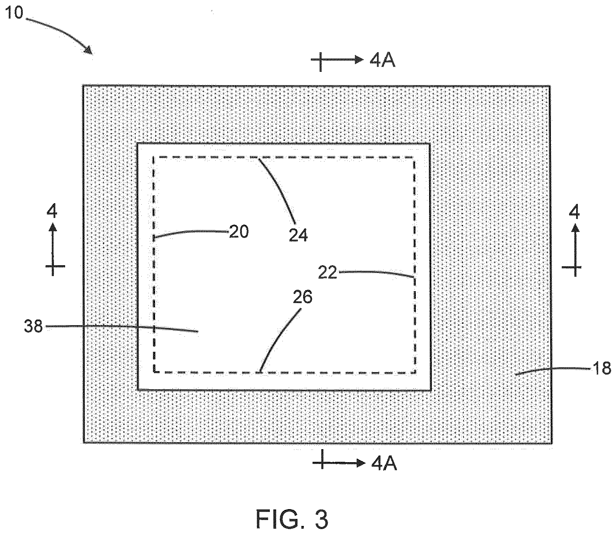

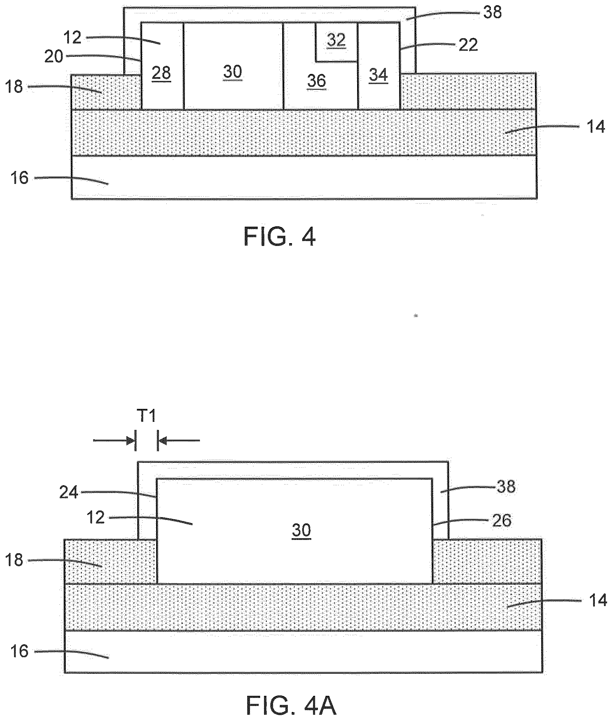

With reference to FIGS. 3, 4, 4A in which like reference numerals refer to like features in FIGS. 1, 2, 2A and at a subsequent fabrication stage, the structure 10 may include a gate dielectric layer 38 that is formed on the upper portion of the semiconductor layer 12. In an embodiment, the gate dielectric layer 38 may be comprised of silicon dioxide. In an embodiment, the gate dielectric layer 38 may be comprised of silicon dioxide formed by thermal oxidation of the semiconductor material of the semiconductor layer 12. Although not shown, a thin surface layer of the semiconductor layer 12 may be consumed by the formation of the gate dielectric layer 38. In an embodiment, the gate dielectric layer 38 may have a thickness in a range of about 100 nanometers (nm) to about 300 nm.

The gate dielectric layer 38 coats all the surfaces of the upper portion of the semiconductor layer 12. In that regard, the gate dielectric layer 38 overlaps with all sidewalls 20, 22, 24, 26 and the top surface 25 of the upper portion of the semiconductor layer 12. The gate dielectric layer 38 wraps about the edges and corners of the upper portion of the semiconductor layer 12 defined by the respective intersections of the sidewalls 20, 22, 24, 26 with the top surface 25. In an embodiment, the gate dielectric layer 38 on the sidewalls 20, 22, 24, 26 and the top surface 25 may have a thickness T1 that is uniform. In an alternative embodiment, the gate dielectric layer 38 on the sidewalls 20, 22, 24, 26 and the top surface 25 may have a thickness T1 that is substantially uniform. In an embodiment, the gate dielectric layer 38 may directly contact the sidewalls 20, 22, 24, 26 and the top surface 25.

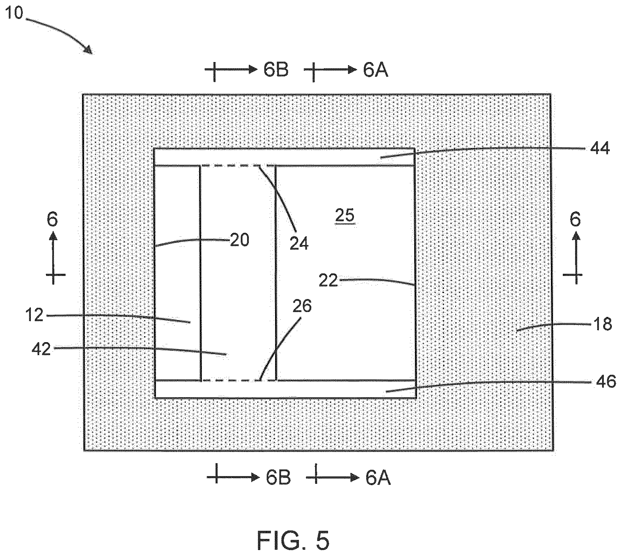

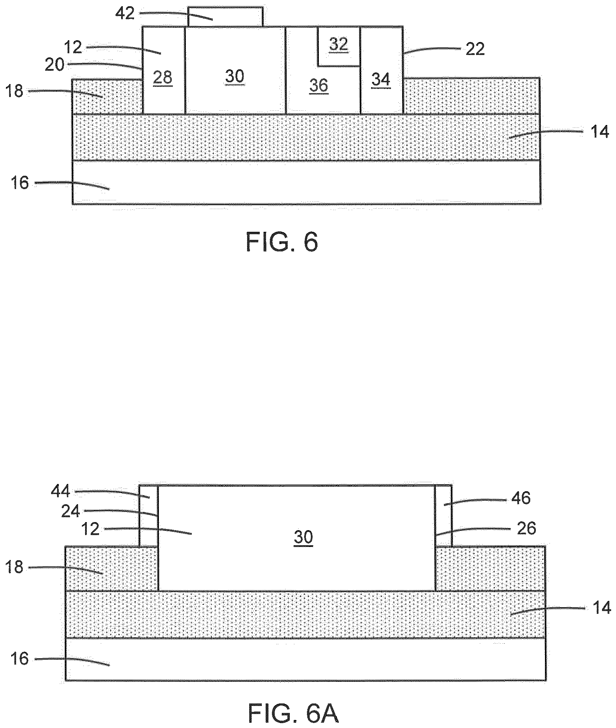

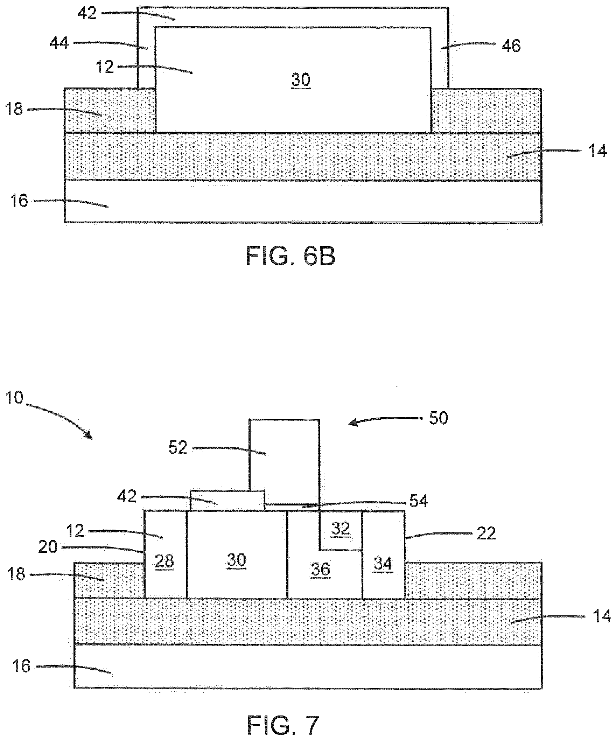

With reference to FIGS. 5, 6, 6A, 6B in which like reference numerals refer to like features in FIGS. 3, 4, 4A and at a subsequent fabrication stage, the gate dielectric layer 38 may be patterned by lithography and etching process to define sections 42, 44, 46. The section 42 of the gate dielectric layer 38 is disposed on the top surface 25 of the semiconductor layer 12. In an embodiment, the top surface 25 between the section 42 and each of the sidewalls 20, 22 may be exposed after the gate dielectric layer 38 is patterned. The section 42 of the gate dielectric layer 38 overlaps with the drift region defined by the doped region 30. The section 44 of the gate dielectric layer 38 is disposed adjacent to the sidewall 24 of the upper portion of the semiconductor layer 12. The section 46 of the gate dielectric layer 38 is disposed adjacent to the sidewall 26 of the upper portion of the semiconductor layer 12. In an embodiment, the sections 44, 46 of the gate dielectric layer 38 may be disposed on the respective sidewalls 24, 26. The section 44 of the gate dielectric layer 38 overlaps with a portion of the shallow trench isolation region 18 adjacent to the sidewall 24, and the section 46 of the gate dielectric layer 38 overlaps with a portion of the shallow trench isolation region 18 adjacent to the sidewall 26. The section 42 of the gate dielectric layer 38 may extend across the top surface 25 of the semiconductor layer 12 from the section 44 of the gate dielectric layer 38 to the section 46 of the gate dielectric layer 38 such that the section 44 is connected by a strip of dielectric material to the section 46.

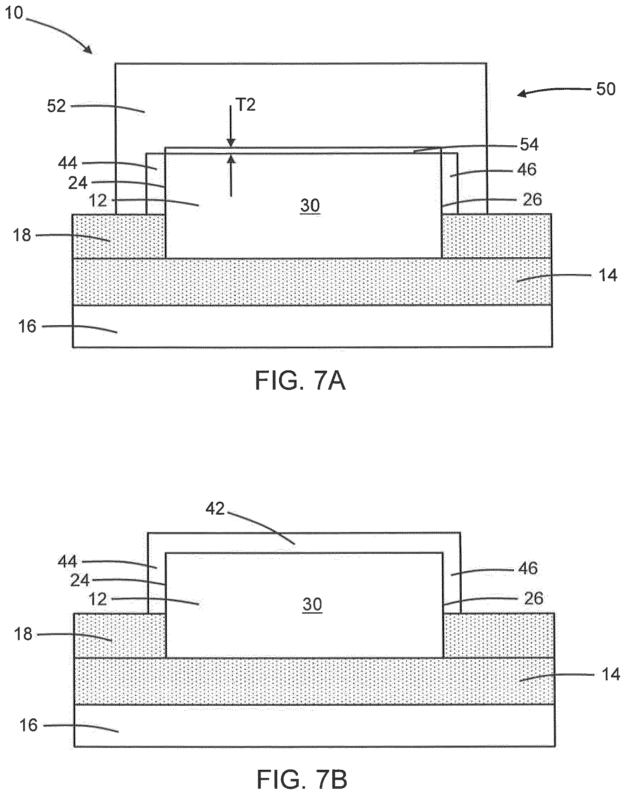

With reference to FIG. 7, 7A, 7B in which like reference numerals refer to like features in FIGS. 5, 6A, 6B and at a subsequent fabrication stage, a gate 50 is formed that includes a gate conductor layer 52 and a gate dielectric layer 54 that is overlapped by the gate conductor layer 52. The gate dielectric layer 54 is comprised of a dielectric material, such as silicon dioxide. In an embodiment, the gate dielectric layer 54 may be formed by thermal oxidation of the semiconductor layer 12 that are not covered by the sections 42, 44, 46 of the gate dielectric layer 38. The gate dielectric layer 54 overlaps with a portion of the drift region defined by the doped region 30 and a portion of the body defined by the doped region 36. The gate dielectric layer 54 has a thickness T2, and the thickness T1 of the sections 42, 44, 46 of the gate dielectric layer 38 is greater than the thickness T2. In an embodiment, the thickness T1 may be at least two times the thickness T2. The gate conductor layer 52 may be comprised of a conductor, such as doped polysilicon. The gate 50 is defined by patterning the gate conductor layer 52 and gate dielectric layer 54 with lithography and etching processes.

The gate conductor layer 52 overlaps with a portion of the section 42 of the gate dielectric layer 38 on the top surface 25. The gate conductor layer 52 overlaps with a portion of the section 44 of the gate dielectric layer 38 at the sidewall 24. The overlapped portion of the section 44 is disposed along the sidewall 22 between respective non-overlapped portions of the section 44. The gate conductor layer 52 overlaps with a portion of the section 46 of the gate dielectric layer 38 at the sidewall 26. The overlapped portion of the section 46 is disposed along the sidewall 26 between respective non-overlapped portions of the section 46. The section 42 of the gate dielectric layer 38 is disposed vertically between a portion of the gate conductor layer 52 and the semiconductor layer 12, the section 44 of the gate dielectric layer 38 is disposed laterally between a portion of the gate conductor layer 52 and the semiconductor layer 12 at the sidewall 24, and the section 46 of the gate dielectric layer 38 is disposed laterally between a portion of the gate conductor layer 52 and the semiconductor layer 12 at the sidewall 26.

The dual thicknesses of dielectric material provided by the sections 42, 44, 46 of the thick gate dielectric layer 38 and the thin gate dielectric layer 54 may function to improve performance metrics of the extended-drain metal-oxide-semiconductor device during device operation. The dual thicknesses of dielectric material provided by the sections 42, 44, 46 of the thick gate dielectric layer 38 and the thin gate dielectric layer 54 may reduce or eliminate the existence of charge trapping centers at the drift region defined by the doped region 30 or under the gate 50, which may lessen the limitations on breakdown voltage and prompt shift of the extended-drain metal-oxide-semiconductor device. The dual thicknesses of dielectric material provided by the sections 42, 44, 46 of the thick gate dielectric layer 38 and the thin gate dielectric layer 54 may function to increase the breakdown voltage. The dual thicknesses of dielectric material provided by the sections 42, 44, 46 of the thick gate dielectric layer 38 and the thin gate dielectric layer 54 may also function to reduce prompt shift.

The methods as described above are used in the fabrication of integrated circuit chips. The resulting integrated circuit chips can be distributed by the fabricator in raw wafer form (e.g., as a single wafer that has multiple unpackaged chips), as a bare die, or in a packaged form. The chip may be integrated with other chips, discrete circuit elements, and/or other signal processing devices as part of either an intermediate product or an end product. The end product can be any product that includes integrated circuit chips, such as computer products having a central processor or smartphones.

References herein to terms modified by language of approximation, such as "about", "approximately", and "substantially", are not to be limited to the precise value specified. The language of approximation may correspond to the precision of an instrument used to measure the value and, unless otherwise dependent on the precision of the instrument, may indicate +/- 10% of the stated value(s).

References herein to terms such as "vertical", "horizontal", etc. are made by way of example, and not by way of limitation, to establish a frame of reference. The term "horizontal" as used herein is defined as a plane parallel to a conventional plane of a semiconductor substrate, regardless of its actual three-dimensional spatial orientation. The terms "vertical" and "normal" refer to a direction in the frame of reference perpendicular to the horizontal, as just defined. The term "lateral" refers to a direction in the frame of reference within the horizontal plane.

A feature "connected" or "coupled" to or with another feature may be directly connected or coupled to or with the other feature or, instead, one or more intervening features may be present. A feature may be "directly connected" or "directly coupled" to or with another feature if intervening features are absent. A feature may be "indirectly connected" or "indirectly coupled" to or with another feature if at least one intervening feature is present. A feature "on" or "contacting" another feature may be directly on or in direct contact with the other feature or, instead, one or more intervening features may be present. A feature may be "directly on" or in "direct contact" with another feature if intervening features are absent. A feature may be "indirectly on" or in "indirect contact" with another feature if at least one intervening feature is present. Different features "overlap" if a feature extends over, and covers a part of, another feature.

The descriptions of the various embodiments of the present invention have been presented for purposes of illustration but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure for an extended-drain metal-oxide-semiconductor device, the structure comprising:
a semiconductor layer including a first sidewall and a top surface;
a source region in the semiconductor layer;
a drain region in the semiconductor layer; and
a gate positioned between the source region and the drain region, the gate including a gate conductor layer, a first gate dielectric layer having a first thickness, and a second gate dielectric layer having a second thickness greater than the first thickness, the first gate dielectric layer on the top surface of the semiconductor layer, the second gate dielectric layer including a first section on the top surface of the semiconductor layer and a second section adjacent to the first sidewall of the semiconductor layer, and the gate conductor layer having an overlapping relationship with the first gate dielectric layer, the first section of the second gate dielectric layer, and the second section of the second gate dielectric layer.

2. The structure of claim 1 further comprising:
a shallow trench isolation region in the semiconductor layer,
wherein the second section of the second gate dielectric layer overlaps with the shallow trench isolation region.

3. The structure of claim 2 further comprising:
a substrate; and
a dielectric layer on the substrate,
wherein the semiconductor layer is disposed on the dielectric layer, and the shallow trench isolation region penetrates through the semiconductor layer to the dielectric layer.

4. The structure of claim 2 or claim 3 wherein the semiconductor layer includes a device region surrounded by the shallow trench isolation region, and the device region includes a portion that projects above the shallow trench isolation region, and, optionally, wherein the first sidewall of the semiconductor layer extends from the shallow trench isolation region to the top surface of the semiconductor layer.

5. The structure of one of claims 1 to 4 wherein the first sidewall extends from the source region to the drain region.

6. The structure of one of claims 1 to 5 wherein the semiconductor layer includes a second sidewall, and the second gate dielectric layer includes a third section adjacent to the second sidewall of the semiconductor layer, and, optionally, wherein the second section of the second gate dielectric layer is disposed on the first sidewall of the semiconductor layer, and the third section of the second gate dielectric layer is disposed on the second sidewall of the semiconductor layer.

7. The structure of claim 6 wherein the first section of the second gate dielectric layer extends across the top surface of the semiconductor layer from the second section of the second gate dielectric layer to the third section of the second gate dielectric layer, and/or wherein the first gate dielectric layer extends across the top surface of the semiconductor layer from the second section of the second gate dielectric layer to the third section of the second gate dielectric layer.

8. The structure of claim 7 wherein the first sidewall of the semiconductor layer is aligned parallel to the second sidewall of the semiconductor layer.

9. The structure of one of claims 6 to 8 wherein the second section of the second gate dielectric layer is laterally between the gate conductor layer and the semiconductor layer at the first sidewall, and the third section of the second gate dielectric layer is laterally between the gate conductor layer and the semiconductor layer at the second sidewall, and/or wherein the gate conductor layer overlaps with a portion of the second section of the second gate dielectric layer, and the gate conductor layer overlaps with a portion of the third section of the second gate dielectric layer.

10. The structure of one of claims 1 to 9 wherein the second section of the second gate dielectric layer is disposed on the first sidewall of the semiconductor layer, and, optionally, wherein the second section of the second gate dielectric layer directly contacts the first sidewall of the semiconductor layer.

11. The structure of one of claims 1 to 10 wherein the gate conductor layer overlaps with a first portion of the second section of the second gate dielectric layer.

12. The structure of claim 11 wherein the drain region includes a first doped region in the semiconductor layer, the source region includes a second doped region in the semiconductor layer, the second section of the second gate dielectric layer includes a second portion adjacent to the first doped region, and the second section of the second gate dielectric layer includes a third portion adjacent to the second doped region.

13. The structure of one of claims 1 to 12 wherein the second thickness of the second gate dielectric layer is in a range of about 100 nanometers to about 300 nanometers.

14. The structure of one of claims 1 to 13 wherein the first section of the second gate dielectric layer is vertically between the gate conductor layer and the semiconductor layer, and the second section of the second gate dielectric layer is laterally between the gate conductor layer and the semiconductor layer at the first sidewall.

15. A method of forming a structure for an extended-drain metal-oxide-semiconductor device, the method comprising:
forming a source region in a semiconductor layer;
forming a drain region in the semiconductor layer; and
forming a gate positioned between the source region and the drain region,
wherein the gate includes a gate conductor layer, a first gate dielectric layer having a first thickness, and a second gate dielectric layer having a second thickness greater than the first thickness, the first gate dielectric layer is disposed on a top surface of the semiconductor layer, the second gate dielectric layer includes a first section on the top surface of the semiconductor layer and a second section adjacent to a sidewall of the semiconductor layer, and the gate conductor layer has an overlapping relationship with the first gate dielectric layer, the first section of the second gate dielectric layer, and the second section of the second gate dielectric layer.
